# EUROPÄISCHE PATENTANMELDUNG

(11) **EP 1 499 015 A1**
(43) Veröffentlichungstag der Anmeldung: **19.01.2005**
(21) Anmeldenummer: 03016250.7
(22) Anmeldetag: 17.07.2003
(51) Int. Cl.: H03G 3/30, H03F 1/32

(54) **Schaltungsanordnung und Verfahren zur Linearisierung einer Kennlinie eines GSM-Leistungsverstärkers**

(71) Anmelder: SIEMENS AKTIENGESELLSCHAFT, 80333 München (DE)
(72) Erfinder: Langer, Andreas, 85716 Unterschleissheim-Lohhof (DE)

(57) **Zusammenfassung**

Die Erfindung betrifft eine Schaltungsanordnung und ein Verfahren zur Linearisierung einer Kennlinie eines GSM-Leistungsverstärkers (6), der mindestens über einen Signaleingang (6.1), einen Signalsausgang (6.2) und einen Vapc-Eingang (6.3) zur Einstellung der Ausgangsleistung verfügt, wobei am Signaleingang (6.1) phasen- und amplitudenmodulierte Signale (17) eines Basisbandes mit einem Vorverstärker (20) eingespeist werden, die am Signalausgang (6.2) als verstärkte Signale ausgeben werden.

Die Erfindung zeichnet sich dadurch aus, dass mit einem Regelkreis (18) die Signale am Eingang (6.1) und am Ausgang (6.2) des Verstärkers miteinander verglichen werden und danach die Spannung am Vapc-Eingang (6.3) und die Phase des eingespeisten Signals (17) eingestellt werden.

## Beschreibung

Die Erfindung betrifft eine Schaltungsanordnung zur Linearisierung einer Kennlinie eines GSM-Leistungsverstärkers, der mindestens über einen Signaleingang, einen Signalsausgang und einen Vapc-Eingang verfügt, wobei am Signaleingang phasenund amplitudenmodulierte Signale eines Basisbandes mit einem Vorverstärker eingespeist werden, die am Signalausgang als verstärkte Signale ausgeben werden und über eine Spannung, die am Vapc-Eingang angelegt wird, die Ausgangsleistung des GSM-Leistungsverstärkers einstellbar ist.

Des weiteren betrifft die Erfindung ein Verfahren zur Linearisierung einer Kennlinie eines GSM-Leistungsverstärkers, wobei phasen- und amplitudenmodulierte Signale in den Signaleingang eines GSM-Leistungsverstärkers eingespeist werden und am Signalausgang als verstärkte Signale ausgeben werden und zur Regulierung der Verstärkerausgangsleistung die Spannung am Vapc-Eingang des GSM-Leistungsverstärkers eingestellt wird.

GSM-Leistungsverstärker (GSM = global system for mobile communications) sind für GMSK-Modulation (GMSK = gaussian minimum shift keying) optimiert. GMSK ist ein Modulationsverfahren mit konstanter Einhüllenden, wodurch der Leistungsverstärker eines GMSK-Senders nichtlinear betrieben werden kann. Durch die nichtlineare Betriebsweise kann der Wirkungsgrad des Leistungsverstärkers verbessert werden. Im wesentlichen führen zwei Ursachen in einem GSM-Leistungsverstärker zu einem nichtlinearen Verhalten, zum einen der AB-Betrieb des GSM-Leistungsverstärkers und zum anderen Sättigungseffekte. Beide Ursachen werden gezielt genutzt, um den Wirkungsgrad des GSM-Leistungsverstärkers zu optimieren.

Bei Modulationsverfahren mit nichtkonstanter Einhüllenden, wie beispielsweise 8-PSK (PSK = phase shift keying = Phasenumtastung bei der Modulation) bei EDGE (enhanced data service for GSM evolution), werden jedoch lineare Leistungsverstärker mit lineare Verstärkerkennlinie benötigt, um die strengen Anforderungen hinsichtlich Nachbarkanalleistung zum Beispiel ACLR (Adjacent Channel Leakage Ratio) bei UMTS und Modulationsgenauigkeit, wie zum Beispiel bei EVM (= Error Vector Magnitude) bei EDGE oder UMTS zu erfüllen.

Dies bedeutet, dass in Dual-Mode Mobilfunkgeräten zum Beispiel bei GSM und EDGE, der für GSM optimierte Leistungsverstärker nicht ohne zusätzliche Maßnahmen für die lineare Modulation genutzt werden kann.

Grundsätzlich existieren zwei Ansätze, um einen für GSM optimierten Leistungsverstärker auch für Modulationsverfahren mit nichtkonstanter Einhüllenden zu nutzen.

Eine Möglichkeit besteht darin, die Betriebsweise des Leistungsverstärkers umzuschalten.

Das Umschalten der Betriebsweise erfolgt durch Änderung des Arbeitspunktes vom AB-Betrieb auf schwachen AB-Betrieb oder A-Betrieb und/oder Loadline-Switching, das heißt das Anpassnetzwerk des Leistungsverstärkers wird geschaltet. Vorteil einer solchen Lösung ist, dass im Mobilfunkgerät kein zusätzlicher Implementierungsaufwand entsteht. Der Leistungsverstärker verfügt in der Regel über einen zusätzlichen Mode-Switch, mit welchem die gewünschte Betriebsart eingestellt werden kann.

Nachteilig ist jedoch, dass sich dieses Konzept bisher nicht befriedigend umsetzen lässt. Entweder werden die Eigenschaften, wie Effektivität und Ausgangsleistung, des GSM-Leistungsverstärkers zu sehr verschlechtert, oder die Anforderungen des linearen Modulationsverfahrens, zum Beispiel bei EDGE, werden nicht ausreichend erfüllt.

Die zweite Möglichkeit, um einen für GSM optimierten Leistungsverstärker auch für Modulationsverfahren mit nichtkonstanter Einhüllenden zu nutzen, besteht darin, den Leistungsverstärker in geeigneter Weise zu linearisieren. Als geeignete Linearisierungsverfahren sind zum Beispiel Polar Loop, Cartesian Feedback oder Predistortion (Signalvorverzerrung) bekannt.

Diese Linearisierungsverfahren, wie speziell Polar Loop, sind vom Ergebnis zwar vielversprechend, führen jedoch zu einem erhöhten Implementierungsaufwand im Mobilfunkgerät.

Es ist daher Aufgabe der Erfindung, eine Schaltungsanordnung vorzustellen, welche die Nutzung eines GSM-Leistungsverstärkers auch für Modulationsverfahren mit nichtkonstanter Einhüllenden, insbesondere 8-PSK (EDGE), ermöglicht, und die mit geringem Implementierungsaufwand im Mobilfunkgerät integriert werden kann. Entsprechend ist es Aufgabe der Erfindung, ein Verfahren zum Betreiben eines GSM-Leistungsverstärkers vorzustellen, das es ermöglicht, den GSM-Leistungsverstärker auch zur Verstärkung von Signalen mit nichtkonstanter Einhüllenden zu nutzen.

Diese Aufgaben der Erfindung werden gegenständlich durch eine Schaltungsanordnung mit den Merkmalen des Patentanspruches 1 und durch den Verfahrensanspruch 7 gelöst. Vorteilhafte Weiterbildungen der Erfindung sind Gegenstand untergeordneter Patentansprüche.

Entsprechend diesem Erfindungsgedanken schlägt der Erfinder vor, eine Schaltungsanordnung zur Linearisierung einer Kennlinie eines GSM-Leistungsverstärkers, der mindestens über einen Signaleingang, einen Signalsausgang und einen Vapc-Eingang verfügt, wobei am Signaleingang phasen- und amplitudenmodulierte Signale eines Basisbandes mit einem Vorverstärker eingespeist werden, die am Signalausgang als verstärkte Signale ausgeben werden und über eine Spannung, die am Vapc-Eingang angelegt wird, die Ausgangsleistung des GSM-Leistungsverstärkers einstellbar ist, dahingehend zu verbessern, dass mindestens ein Regelkreis angeordnet ist, der die Spannung am Vapc-Eingang und die Phase der modulierten Signale regelt.

Durch diese neue Schaltungsanordnung kann nun ein Standard GSM-Leistungsverstärker auch für Modulationsverfahren mit nichtkonstanter Einhüllenden, vorzugsweise 8-PSK bei EDGE, genutzt werden.

Außerdem kann der Wirkungsgrad des Leistungsverstärkers gegenüber Leitungsverstärkern mit rein linearer Kennlinie erhöht werden, da der Stromflusswinkel der Einhüllenden angepasst wird. Hier bezeichnet der Stromflusswinkel den Winkelbereich, in dem bei einem Leistungsverstärker der Strom fließt, zum Beispiel 90° bei B-Verstärkern.

Die Schaltungsanordnung kann für GMSK-Signale als Leistungsregelung genutzt werden. Das Ramping erfolgt über Pout_adj des Verstärkers im Regelkreis. Hierfür ist keine zusätzliche Regelung notwendig.

Ein weiterer Vorteil, der sich durch die neue Schaltungsanordnung ergibt, ist, dass kein Isolator benötigt wird.

Es ist vorteilhaft, wenn in der Schaltungsanordnung ein separater Phasenregelkreis für die Phasenkorrektur des modulierten Signals am Signaleingang vorgesehen ist. Wird die Spannung am Vapc-Eingang variiert, wird hierdurch nicht nur die AM-AM Charakteristik des Leistungsverstärkers beeinflusst, sondern zusätzlich auch die AM-PM Charakteristik. Durch den Phasenregelkreis kann die AM-PM Variation des Leistungsverstärkers kompensiert werden.

Entsprechend ist es vorteilhaft, wenn ein separater Spannungsregelkreis für die Spannung am Vapc-Eingang vorgesehen ist. Hierdurch kann über die Spannung am Vapc-Eingang die Leistung des GSM-Leistungsverstärkers unabhängig von der Phase des Signals geregelt werden.

In der Schaltungsanordnung ermöglicht zumindest ein Koppler, dass die Signale am Signalausgang des GSM-Leistungsverstärkers auskoppelt werden können.

Die Schaltungsanordnung verfügt über zumindest eine Signalabtasteinheit, vorzugsweise mit einem Mischer, einem A/D-Converter und einem Time Delay, die die ausgekoppelten Signale abtastet.

Es ist vorteilhaft, dass der Regelkreis zumindest einen Verstärker aufweist, der die ausgekoppelten Signale verstärkt. Mittels des Verstärkers kann der Gain im Rückführungszweig falls notwendig auf einen gewünschten Wert eingestellt werden, wodurch der lineare Gain der Anordnung beeinflusst wird. Im constant-envelope-Betrieb, also bei Signalen mit konstanter Einhüllenden, zum Beispiel GMSK, dient der Verstärker zur Leistungsregelung. Je nach Anwendung kann der Verstärker auch einen negativen Gain besitzen, wirkt also als Dämpfungsglied.

Entsprechend der neuen Schaltungsanordnung schlägt der Erfinder auch ein Verfahren zur Linearisierung einer Kennlinie eines GSM-Leistungsverstärkers vor, wobei phasen- und amplitudenmodulierte Signale in den Signaleingang eines GSM-Leistungsverstärkers eingespeist und am Signalausgang als verstärkte Signale ausgeben werden und zur Regulierung der Verstärkerausgangsleistung die Spannung am Vapc-Eingang des GSM-Leistungsverstärkers eingestellt wird. Im neuen Verfahren wird die Linearisierung des GSM-Leistungsverstärkers dadurch erreicht, dass die Signale am Eingang und am Ausgang des Verstärkers miteinander verglichen werden und danach die Spannung am Vapc-Eingang und die Phase des eingespeisten Signals eingestellt werden.

Wird die Spannung am Vapc-Eingang in Abhängigkeit von der momentanen Eingangsleistung eingestellt, so ist es möglich, eine konstante Verstärkung über einen Großteil des Eingangsleistungsbereiches zu realisieren. Der GSM-Leistungsverstärker kann somit auch Signale mit nichtkonstanter Einhüllenden linear verstärken.

Für das Verfahren ist es günstig, wenn die Signale am Eingang und am Ausgang des GSM-Leistungsverstärkers nach Betrag und Phase aufgespalten werden.

Es ist vorteilhaft, wenn die Beträge und die Phasen der Eingangs- und Ausgangssignale miteinander verglichen werden.

Im neuen Verfahren kann die Spannung am Vapc-Eingang bis zu einem definierten Wert der Eingangsleistung erhöht werden und ab dem definierten Wert erniedrigt werden. Hierdurch wird eine Leistungserhöhung des GSM-Leistungsverstärkers erreicht.

Es ist vorteilhaft, wenn der Verlauf der Spannung am Vapc-Eingang überwacht wird. Hierbei kann dann die Steigung der Spannungskurve am Vapc-Eingang, also die Änderung der Spannung über der Zeit des Stellsignals, überwacht werden. Mit Hilfe der Steigung der Spannungskurve und zum Beispiel einem monotonen Steigungsverhalten beziehungsweise der Änderung des Monotonieverhaltens kann dann auf eine Sättigung des GSM-Leistungsverstärkers, zum Beispiel infolge Fehlanpassung, geschlossen werden. Das nichtlineare Verhalten des GSM-Leistungsverstärkers infolge von Sättigung kann über eine Änderung der Verstärkung des Spannungsregelkreises wieder kompensiert werden. Hierdurch kann der lineare Bereich der Verstärkerkennlinie erhöht werden.

Es ist vorteilhaft, sowohl die neue Schaltungsanordnung als auch das Verfahren in Multimode Geräten der Telekommunikation einzusetzen. Die Schaltungsanordnung und das Verfahren können dann beispielsweise bei Signalen mit konstanter Einhüllenden zur Regelung der Verstärkerleistung benutzt werden. So ist dann zum Beispiel bei GMSK bei GSM keine Linearisierung mehr notwendig.

Weitere Merkmale der Erfindung ergeben sich aus den Unteransprüchen und der nachfolgenden Beschreibung der Ausführungsbeispiele unter Bezugnahme auf die Zeichnungen.

Im folgenden wird die Erfindung anhand der Zeichnungen näher beschrieben:
- Figur 1:: Verstärkerkennlinien für verschiedene Spannungen am Vapc-Eingang eines GSM-Leistungsverstärkers;
- Figur 2:: Schaltungsanordnung zur Linearisierung der Kennlinie eines GSM-Leistungsverstärkers;
- Figur 3:: Kennlinie, in der die Spannung am Vapc-Eingang gegen die Eingangsleistung Pin aufgetragen ist.

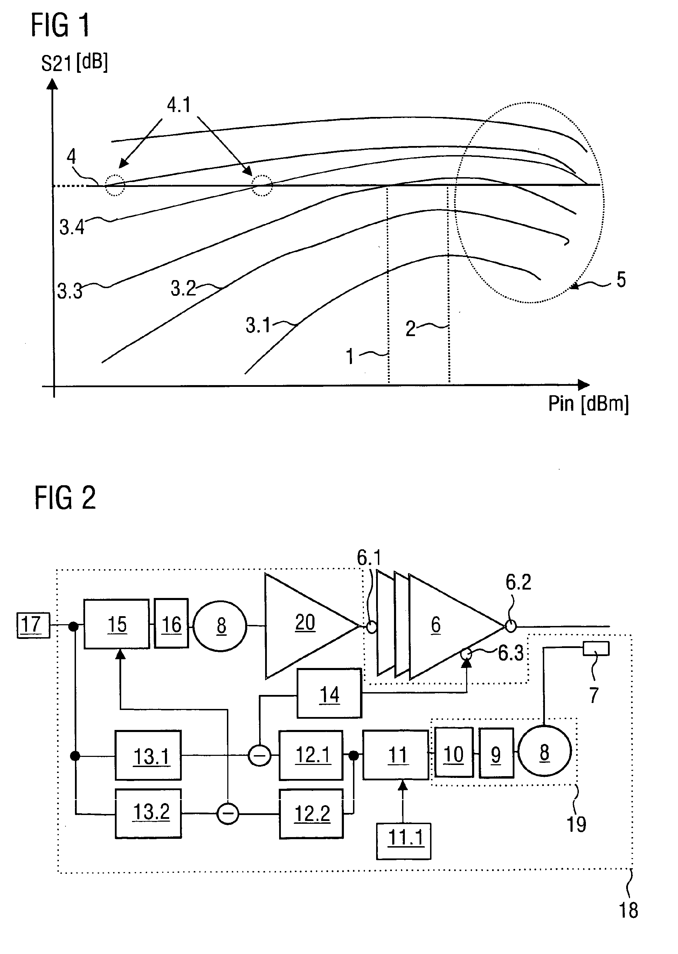

Die Figur 1 zeigt ein Diagramm mit mehreren Verstärkerkennlinien eines GSM-Leistungsverstärkers. Auf der Abszisse ist die Eingangsleistung Pin in [dBm] aufgetragen, wobei die Einheit in den eckigen Klammern die mit dem Faktor 10 multiplizierte logarithmische Leistung bezogen auf 1 Milliwatt beschreibt. Auf der Ordinate ist die Großsignalverstärkung in einer s21 Darstellung in [dB = Dezibel] aufgetragen. Hierbei beschreibt der S-Parameter die Transmission. In diesem Zusammenhang im wesentlichen die Verstärkung in dB also das logarithmische Verhältnis von Ausgangs- zu Eingangsleistung.

GSM-Leistungsverstärker besitzen in der Regel einen Vapc-Eingang. Über den Vapc-Eingang kann mit Hilfe einer externen Spannung die Ausgangsleistung des GSM-Leistungsverstärkers eingestellt werden.

Aufgrund der konstanten Einhüllenden bei der GMSK-Modulation werden GSM-Leistungsverstärker mit einer konstanten Eingangsleistung betrieben. Bei Modulationsverfahren mit nichtkonstanter Einhüllenden ändert sich die momentane Eingangsleistung in Abhängigkeit der momentanen Datensequenz im Basisband. Man definiert daher eine mittlere Eingangsleistung Pin_average 1 und eine maximale Eingangsleistung Pin_peak 2.

Im Diagramm ist nun die AM-AM Charakteristik in der s21 Darstellung eines GSM-Leistungsverstärkers als Kennlinienschar in Abhängigkeit der Vapc-Spannung dargestellt. Man erkennt, dass die Verstärkung des GSM-Leistungsverstärkers abhängig von der Vapc-Spannung ist. So ist deutlich zu erkennen, dass die Verstärkungskennlinie mit einer größeren Vapc-Spannung oberhalb einer Verstärkerkennlinie mit kleinerer Vapc-Spannung verläuft. Für die Werte der Verstärkerkennlinien ist dem Diagramm folgendes zu entnehmen:
Verstärkungskennlinie 3.4 > Verstärkungskennlinie 3.3 >
Verstärkungskennlinie > 3.2 Verstärkungskennlinie 3.1

Wobei für die Vapc-Spannungen gilt.

Vapc-Spannung 4 > Vapc-Spannung 3 > Vapc-Spannung 2 > Vapc-Spannung 1.

Zusätzlich ändert sich die Verstärkung mit der Eingangsleistung Pin. Mit steigender Eingangsleistung nimmt die Verstärkung für eine bestimmte Vapc-Spannung zu. Der Grund hierfür ist der AB-Betrieb. Oberhalb einer bestimmten Eingangsleistung nimmt die Verstärkung wieder ab.

Der Sättigungsbereich 5, ab dem die Verstärkung wieder abnimmt, ist in Figur 1 durch das gepunktet eingerahmte Feld gekennzeichnet.

Grund hierfür sind Sättigungseffekte, zum Beispiel eine Strom- oder Spannungssättigung. Soll nun eine konstante Verstärkung s21_soll 4 über den gesamten Eingangsleistungsbereich erzielt werden, so muss für eine momentane Leistung unterhalb der mittleren Eingangsleistung Pin_average 1 die Vapc-Spannung in Abhängigkeit von der momentanen Eingangsleistung angehoben werden, da eine größere Vapc-Spannung zu einer größeren Verstärkung führt, während die Vapc-Spannung für eine momentane Leistung oberhalb der mittleren Eingangsleistung Pin_average 1 verringert werden muss.

Wird die Vapc-Spannung also in geeigneter Weise in Abhängigkeit von der momentanen Eingangsleistung nachgeführt, so ist es möglich, eine konstante Verstärkung über einen Großteil des Eingangsleistungsbereiches zu realisieren. Der Leistungsverstärker kann somit auch Signale mit nichtkonstanter Einhüllenden linear verstärken.

Die Figur 2 zeigt die erfindungsgemäße Schaltungsanordnung zur Linearisierung der Kennlinie eines GSM-Leistungsverstärkers 6. Dieser GSM-Leistungsverstärker 6 hat einen Signaleingang 6.1, an dem die zu verstärkenden sowohl hinsichtlich der Phase als auch der Amplitude modulierten Signale 17 des Basisbandes mit einem Vorverstärker 20 eingespeist werden, und einen Signalausgang 6.2, an dem die verstärkten Signale ausgegeben werden. Außerdem verfügt dieser GSM-Leistungsverstärkers 6 über einen Vapc-Eingang 6.3, an dem über eine externe Spannung die Ausgangsleistung des GSM-Leistungsverstärkers 6 eingestellt werden kann.

Das Ausgangssignal am Signalausgang 6.2 des GSM-Leistungs-Verstärkers 6 wird mit einem Koppler 7 ausgekoppelt. Mit einem Mischer 8 wird das ausgekoppelte Signal in die Basisband-Ebene gemischt. Das Ausgangsignal wird mit einem Analog-Digital-Converter 9 und einem Time Delay 10 abgetastet. Anschließend wird das abgetastete Signal mit einem Basisbandverstärker 11 verstärkt und nach Betrag des Ausgangssignals 12.1 und Phase des Ausgangssignals 12.2 aufgespalten.

Auch das modulierte Basisbandsignal 17, das am Signaleingang 6.1 des GSM-Leistungsverstärkers 6 eingespeist wird, wird vor der Einspeisung in den GSM-Leistungsverstärkers 6 nach Betrag des Eingangssignals 13.1 und nach Phase des Eingangssignals 13.2 aufgespalten.

In dieser Schaltungsanordnung werden der Betrag des Ausgangssignals 12.1 und der Betrag des Eingangsignals 13.1 aber auch die Phase des Ausgangssignals 12.2 und die Phase des Eingangsignals 13.2 verglichen und über getrennte Regelkreise ausgeregelt.

Der Regelkreis für den Betrag des Signals 14 regelt dann die Spannung am Vapc-Eingang 6.3 des GSM-Leistungsverstärkers 6.

Über den Regelkreis für die Phase des Signals 15 kann das modulierte Basisbandsignal 17 vor der Einspeisung in den GSM-Leistungsverstärker 6 in der Phase angepasst werden.

Über den Basisbandverstärker 11 kann die Verstärkung im Rückführungszweig eingestellt werden und somit die gewünschte Ausgangsleistung des GSM-Leistungsverstärkers 6.

Ein wesentliches Merkmal dieser Schaltungsanordnung ist, dass das Signal am Signaleingang 6.1 des GSM-Leistungsverstärkers 6 ein amplituden- und phasenmoduliertes Signal ist. Hiervon unterscheidet sich diese Linearisierung von der bei Polar Loop. Die nichtlineare Charakteristik des GSM-Leistungsverstärkers 6 wird über die Spannung am Vapc-Eingang 6.3 in Abhängigkeit der momentanen Eingangsleistung korrigiert.

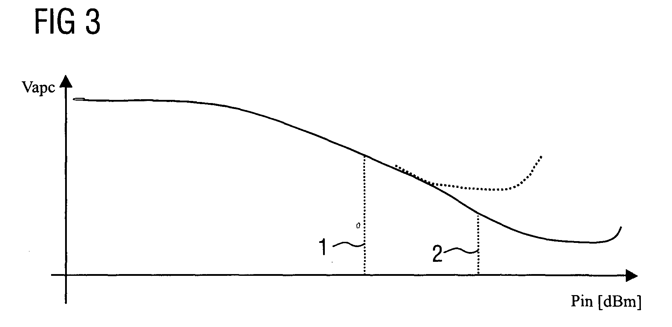

Die Figur 3 zeigt ein Diagramm, in dem die Kennlinie der Vapc-Spannung zur Erreichung einer konstanten Verstärkung s21_soll dargestellt ist. Auf der Abszisse ist die Eingangsleistung Pin in [dBm] und auf der Ordinate ist die Vapc-Spannung aufgetragen. Die Kennlinie der Vapc-Spannung, aufgetragen gegen die Eingangsleistung Pin, ist im Bereich Pin < Pin_average monoton fallend. Für diesen Bereich, in dem die Eingangsleistung kleiner als die mittlere Eingangsleistung Pin_average ist (Pin < Pin_average) muss die Vapc-Spannung angehoben werden.

Im Bereich der Eingangsleistung Pin > Pin_average muss die Verstärkung reduziert werden. In diesem Bereich muss die Vapc-Spannung verkleinert werden. Ohne Sättigungseffekte ist die Kennlinie also monoton fallend. Bei Sättigung hingegen ändert sich das Monotonieverhalten, wodurch die Monotonie ein Indikator für eine eventuelle Sättigung zum Beispiel infolge Fehlanpassung ist.

Insgesamt wird also durch die Erfindung eine Schaltungsanordnung und ein Verfahren zur Linearisierung einer nichtlinearen Kennlinie eines GSM-Leistungsverstärker zur Verfügung gestellt, wobei die Schaltungsanordnung mindestens bestehend aus einem GSM-Leistungsverstärker, der über einen Signaleingang, einen Signalsausgang und einen Vapc-Eingang verfügt, wobei am Signaleingang phasen- und amplitudenmodulierte Signale eines Basisbandes eingespeist werden, die am Signalausgang verstärkt ausgeben werden und über eine Spannung, die am Vapc-Eingang angelegt wird, die Ausgangsleistung des GSM-Leistungsverstärkers einstellbar ist.

Die Linearisierung der Kennlinie des GSM-Leistungsverstärkers wird dadurch erreicht, dass mit einem Regelkreis die Signale am Eingang und am Ausgang des Verstärkers miteinander verglichen werden und danach die Spannung am Vapc-Eingang und die Phase des eingespeisten Signals eingestellt werden.

Es versteht sich, dass die vorstehend genannten und nachstehend noch zu erläuternden Merkmale der Erfindung nicht nur in der jeweils angegebenen Kombination, sondern auch in anderen Kombinationen oder in Alleinstellung verwendbar sind, ohne den Rahmen der Erfindung zu verlassen.

### Liste der verwendeten Abkürzungen:

- ACLR: Adjacent Channel Leakage Ratio
- ACP: Adjacent Channel Power
- ADC: Analog-Digital-Converter (Analog-Digital-Wandler)
- AM: Amplitudenmodulation
- DAC: Digital-Analog-Converter (Digital-Analog- Wandler)
- EDGE: Enhanced Data Service for GSM Evolution
- EVM: Error Vector Magnitude
- GMSK: Gaussian Minimum Shift Keying (GMSK- Modulation)
- GSM: Global System for Mobile Communications (Mobilfunk)
- PA: Power Amplifier (Verstärker)
- Pin_average: Mittlere Eingangsleistung
- Pin_peak: Maximale Eingangsleistung
- PM: Phasenmodulation
- PSK: Phase Shift Keying (Phasenumtastung bei der Modulation)
- Vapc: Spannung am Vapc-Eingang, wobei apc für analog power control steht

### Bezugszeichenliste

- 1: Mittlere Eingangsleistung Pin_average
- 2: Maximale Eingangsleistung Pin_peak
- 3.1: Verstärkungskennlinie für die Vapc-Spannung 1
- 3.2: Verstärkungskennlinie für die Vapc-Spannung 2
- 3.3: Verstärkungskennlinie für die Vapc-Spannung 3
- 3.4: Verstärkungskennlinie für die Vapc-Spannung 4
- 4: Gewünschte Konstante Verstärkung s21_soll
- 4.1: Schnittpunkt der Verstärkungskennlinie mit s21_soll
- 5: Sättigungsbereich
- 6: GSM-Leistungsverstärker PA
- 6.1: Signaleingang des GSM-Leistungsverstärkers
- 6.2: Signalausgang des GSM-Leistungsverstärkers
- 6.3: Vapc-Eingang des GSM-Leistungsverstärkers
- 7: Koppler
- 8: Mischer
- 9: ADC = Analog-Digital-Converter
- 10: Time Delay
- 11: Basisbandverstärker
- 11.1: Pout_adj
- 12.1: Betrag des Ausgangssignals
- 12.2: Phase des Ausgangssignals
- 13.1: Betrag des Eingangssignals
- 13.2: Phase des Eingangssignals
- 14: Regelkreis für den Betrag des Signals/ Spannungsregelkreis
- 15: Regelkreis für die Phase des Signals
- 16: DAC = Digital-Analog-Converter
- 17: Moduliertes Basisbandsignal
- 18: Regelkreis
- 19: Signalabtasteinheit
- 20: Vorverstärker VGA = Variable Gain Amplifier

## Patentansprüche

1. Schaltungsanordnung zur Linearisierung einer Kennlinie eines GSM-Leistungsverstärkers (6), der mindestens über einen Signaleingang (6.1), einen Signalsausgang (6.2) und einen Vapc-Eingang (6.3) verfügt, wobei am Signaleingang (6.1) phasen- und amplitudenmodulierte Signale (17) eines Basisbandes mit einem Vorverstärker (20) eingespeist werden, die am Signalausgang (6.2) als verstärkte Signale ausgeben werden und über eine Spannung, die am Vapc-Eingang (6.3) angelegt wird, die Ausgangsleistung des GSM-Leistungsverstärkers (6) einstellbar ist, **dadurch gekennzeichnet, dass** mindestens ein Regelkreis (18) angeordnet ist, der die Spannung am Vapc-Eingang (6.3) und die Phase der modulierten Signale (17) des Basisbandes regelt.

2. Schaltungsanordnung gemäß dem voranstehenden Patentanspruch 1, **dadurch gekennzeichnet, dass** ein separater Phasenregelkreis (15) für die Phasenkorrektur des modulierten Signals (17) am Signaleingang (6.1) vorgesehen ist.

3. Schaltungsanordnung gemäß einem der voranstehenden Patentansprüche 1 und 2, **dadurch gekennzeichnet, dass** ein separater Spannungsregelkreis (14) für die Spannung am Vapc-Eingang (6.3) vorgesehen ist.

4. Schaltungsanordnung gemäß einem der voranstehenden Patentansprüche 1 bis 3, **dadurch gekennzeichnet, dass** zumindest ein Koppler (7) vorgesehen ist, der die Signale am Signalausgang (6.2) des GSM-Leistungsverstärkers (6) auskoppelt.

5. Schaltungsanordnung gemäß einem der voranstehenden Patentansprüche 1 bis 4, **dadurch gekennzeichnet, dass** der Regelkreis (18) zumindest eine Signalabtasteinheit (19) aufweist, vorzugsweise mit einen Mischer (8), einem A/D-Converter (9) und einem Time Delay (10), die die ausgekoppelten Signale abtastet.

6. Schaltungsanordnung gemäß einem der voranstehenden Patentansprüche 1 bis 5, **dadurch gekennzeichnet, dass** der Regelkreis (18) zumindest einen Verstärker (11) aufweist, der die ausgekoppelten Signale verstärkt.

7. Verfahren zur Linearisierung einer Kennlinie eines GSM-Leistungsverstärkers (6), wobei phasen- und amplitudenmodulierte Signale (17) in den Signaleingang (6.1) eines GSM-Leistungsverstärkers (6) eingespeist und als verstärkte Signale am Signalausgang (6.2) ausgeben werden und zur Regulierung der Verstärkerausgangsleistung die Spannung am Vapc-Eingang (6.3) des GSM-Leistungsverstärkers (6) eingestellt wird, **dadurch gekennzeichnet, dass** die Signale am Eingang (6.1) und am Ausgang (6.2) des GSM-Leistungsverstärkers (6) miteinander verglichen werden und danach die Spannung am Vapc-Eingang (6.3) und die Phase des eingespeisten Signals (17) eingestellt wird.

8. Verfahren gemäß dem voranstehenden Patentanspruch 7, **dadurch gekennzeichnet, dass** die Signale am Eingang (6.1) und am Ausgang (6.2) des GSM-Leistungsverstärkers (6) nach Betrag und Phase aufgespalten werden.

9. Verfahren gemäß einem der voranstehenden Patentansprüche 7 und 8, **dadurch gekennzeichnet, dass** die Beträge (12.1 und 13.1) und die Phasen (12.2 und 13.2) der Eingangs- und Ausgangssignale miteinander verglichen werden.

10. Verfahren gemäß einem der voranstehenden Patentansprüche 7 bis 9, **dadurch gekennzeichnet, dass** die Signale am Signalausgang (6.2) ausgekoppelt und dann verstärkt werden.

11. Verfahren gemäß einem der voranstehenden Patentansprüche 7 bis 10, **dadurch gekennzeichnet, dass** die Spannung am Vapc-Eingang (6.3) bis zu einem definierten Wert (1) der Eingangsleistung erhöht wird und ab dem definierten Wert (1) erniedrigt wird.

12. Verfahren gemäß einem der voranstehenden Patentansprüche 7 bis 11, **dadurch gekennzeichnet, dass** der Verlauf der Spannung am Vapc-Eingang (6.3) überwacht wird.

13. Verwendung einer Schaltungsanordnung, die gemäß einem der voranstehenden Patentansprüche 1 bis 7 ist oder Verwendung eines Verfahrens, das Merkmale gemäß einem der Ansprüche 8 bis 12 aufweist, in Multimode Geräten der Telekommunikation bei Signalen mit konstanter Einhüllenden zur Regelung der Verstärkerleistung.
